(19) Europäisches Patentamt
European Patent Office
Office européen des brevets

(11) **EP 3 822 644 A1**

(12) **EUROPEAN PATENT APPLICATION**

(43) Date of publication:
**19.05.2021 Bulletin 2021/20**

(51) Int Cl.:
*G01R 1/20* (2006.01)        *G01R 19/00* (2006.01)

(21) Application number: **19209775.6**

(22) Date of filing: **18.11.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(71) Applicant: **Mahle International GmbH**
**70376 Stuttgart (DE)**

(72) Inventor: **VEEN, Rolf**
**46520 Puerto de Salgunto (Valencia) (ES)**

(74) Representative: **BRP Renaud & Partner mbB**
**Rechtsanwälte Patentanwälte**
**Steuerberater**
**Königstraße 28**
**70173 Stuttgart (DE)**

(54) **ELECTRICAL CURRENT SENSOR AND MEASURING CIRCUIT**

(57)    The invention relates to an electrical current sensor (1) for determining an electrical current ($I_{Load}$) passed through said sensor (1),
- with an electrical measuring resistor (2), which has a resistance zone (4) made of a shunt material, which is divided by a breakthrough (7) into at least a first and a second zone section (4a, 4b),
- wherein at least one main electrical current path (9) is defined in the electrical measuring resistor (2) and extends from a first electrical terminal (5a) via the at least one first zone section (4a) to a second electrical terminal (5b); and
- wherein an electrical bypass path (10) is defined in the electrical measuring resistor (2) and extends from the first electrical terminal (5a) via the second zone section (4b) to a third electrical terminal (5c).

Fig. 1 a

EP 3 822 644 A1

Fig. 1 b

**Description**

The invention relates to an electrical current sensor and to a measuring circuit for determining an electric current comprising such an electrical current sensor.
Electric currents in and from a vehicle battery are determined with the aid of electrical current sensors via an electrical measuring resistor, also known to a person skilled in the art as a "shunt".
Traditional electrical current sensors have the drawback that, because of the temperature dependency of the electrical resistance of the measuring resistor or current sensor, temperature fluctuations may result in measurement errors in the measured electric current.
Therefore, one problem which the present invention proposes to solve is to create an electrical current sensor which addresses this problem, and in which this problem is at least partly, ideally entirely eliminated. In particular, a current sensor is to be created in which temperature fluctuations in the material of the current sensor and thus concomitant fluctuations of the electrical resistance of this material do not result in measurement errors in the electric current measured or determined by means of the current sensor.
The basic notion of the invention is accordingly to equip an electrical current sensor in the form of an electrical measuring resistor with a measuring section having an elongated cavity. The current sensor is herein configured such that both said cavity and also the region complementary to it - hereinafter also called the "complementary section" - can receive a flow along the longitudinal direction in the manner of a parallel circuit. Thus, two mutually parallel running and electrically parallel-switched electrical current paths are created in the measuring section. The complementary section possesses in this case a first, preferably ohmic, electrical resistor R1, the cavity possesses a second, preferably ohmic, electrical resistor R2. By using a suitable electrical or electronic evaluation circuit it is possible to use the electric current flowing through R2 as a reference electric current, if the current flowing through the overall measuring resistor can be determined. In this way, measurement errors in the determination of the electric current through the measuring resistor that are caused by temperature-related changes in the electrical resistance - especially temperature drifts - can be avoided. In this way, the accuracy of the electric current measurement is improved significantly as compared to traditional current sensors - especially during temperature fluctuations in the material of the current sensor or/and in its environment.
The basic idea of the invention is accordingly to divide an electrical current sensor, i.e. an electrical measuring resistor, into two or more sections: at least one, preferably wide, first zone section, hereafter referred as R1, that carries the current to be measured, and a, preferably thin, second zone section, hereafter referred as R2, that is used as reference. Both sections are to be in close thermal contact. The resistance ratio R1/R2 will be referred hereafter as K. While both sections, R1 and R2, will change with temperature and age, they will do it in a very similar way, and therefore K will remain largely constant. By using a suitable electronic circuit it is possible to use the electric current flowing through R2 as a reference current and obtain the unknown current (flowing through R1) by multiplying the current through R2 by K. In this way, measurement errors in the determination of the electric current through the measuring resistor that are caused by changes in the sensing element - temperature drifts, ageing, etc - can be compensated. As a consequence, the accuracy of the electric current measurement is improved significantly as compared to traditional shunt-based current sensors.
An inventive electrical current sensor for determining an electrical current conducted through this sensor comprises an electrical measuring resistor having a resistive zone from a shunt material. The resistance zone is divided into at least a first and a second zone section by means of a breakthrough. At least one electrical main current path is defined in the electrical measuring resistor and extends from a first electrical terminal via the at least one first zone section to a second electrical terminal. An electrical bypass path extending from the first electrical terminal via the second zone portion to a third electrical terminal is also defined in the electrical measuring resistor. The terminals can be made, for example, by soldering pins or wires on them or making holes for attaching a cable or busbar by means of a bolt and a nut.
In a preferred configuration, the at least a first zone portion and the second zone portion and the breakthrough extend along a common longitudinal direction of the current sensor.
According to an advantageous development, exactly one first zone section and exactly one breakthrough are present. This embodiment is particularly simple and therefore particularly cost-effective to manufacture.
In this advantageous development, the measuring resistor has an essentially U-shaped geometry with a U-base and a first and a second U-leg, whereby the first zone section is part of the first leg and the second zone section is part of the second leg. Such a geometry allows a particularly simple electrical wiring of the measuring resistor with an electrical current source and with an electronic evaluation circuit.
According to another advantageous development of the invention, two first zone sections are provided, whereby in this development the second zone section is arranged transversely to the longitudinal direction between the first two zone sections. In this way, it is possible to obtain an advantageous symmetrical structure of the measuring resistor with respect to the arrangement of the third electrical connection with respect to the second electrical connection.
This embodiment is particularly easy to implement technically if a U-shaped geometry with a base and first and second legs is chosen for the breakthrough, so that the two legs separate the second zone section from one of the first two zone sections.

The breakthrough is particularly useful as it has a slot-like design. Such a breakthrough with slot-like geometry is particularly easy to produce - for example by means of a punching process or laser cutting process - so that there also have cost advantages in the production of the measuring resistor.

Especially preferred are the first and second connection for electrical connection of the main current path to an electrical power source and the third connection for connection to an electrical power source and the third connection for connection of the secondary current path to an electronic evaluation circuit.

The invention moreover relates to a measuring circuit for determining an electric current, comprising at least one electrical current sensor as presented above. The aforementioned benefits of the electrical current sensor therefore also apply to the measuring circuit according to the invention. According to the invention, the current sensor is electrically connected to an electronic evaluation circuit, by means of which the electric current flowing through the measuring section of the electrical measuring resistor can be determined or is determined during the operation of the measuring circuit.

According to one preferred embodiment, the measuring circuit according to the invention comprises a feedback circuit. This is designed such that by means of these temperature-related fluctuations of the resistance value of the measuring resistor when determining the electric current are compensated.

Further important features and benefits of the invention emerge from the dependent claims, from the drawings, and from the corresponding description of the figures with the aid of the drawings.

Of course, the features mentioned above and those yet to be discussed below may be used not only in the particular indicated combination, but also in other combinations or standing alone, without leaving the scope of the present invention.

Preferred exemplary embodiments of the invention are represented in the drawings and are discussed more closely in the following description, the same reference numbers being used for the same or similar or functionally equivalent components.

There are shown, each time schematically:

Fig. 1a    an first example of a current sensor according to the invention in a perspective representation,

Fig. 1b    an second example of a current sensor according to the invention in a perspective representation,

Fig. 2    an equivalent circuit diagram for the current sensor of Figure 1, showing its electrical resistance,

Fig. 3    an example of a measuring circuit according to the invention with the current sensor of Figure 1 in a circuit diagram representation.

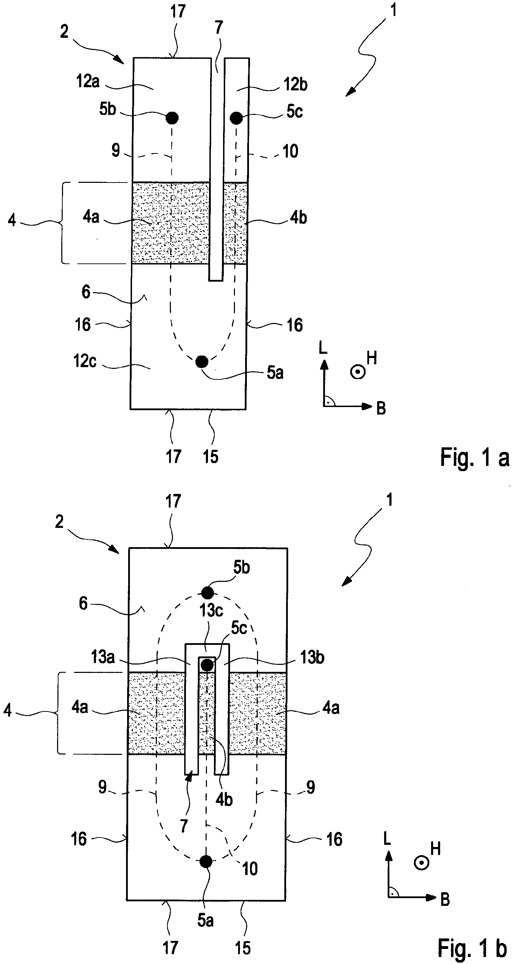

Figure 1a illustrates in a top view and in a very simplified representation a first example of an inventive current sensor 1 for determining a total electric current conducted through this sensor 1. The electrical current sensor 1 comprises an electrical measuring resistor 2, which in turn has a resistance zone 4 made of a shunt material, which is divided into a first and a second zone section 4a, 4b by a breakthrough 7. In the electrical measuring resistor 2 an electrical main current path 9 is provided, which extends from a first electrical terminal 5a via the at least one first zone section 4a to a second electrical terminal 5b. An electrical bypass path 10 extending from the first electrical terminal 5a through the second zone portion 4b to a third electrical terminal 5c is also provided in the electrical measuring resistor 2. The terminals 5a, 5b, 5c can be made, for example, by soldering pins or wires on them or making holes for attaching a cable or busbar by means of a bolt and a nut.

In the example of Figure 1a, the first and second zone sections 4a, 4b and the breakthrough 7 extend along a common longitudinal direction of the current sensor 1. The breakthrough 7 is slot-like. In the example of Figure 1a, exactly one first zone section 4a and exactly one breakthrough 7 are provided. In the example of Figure 1a, the measuring resistor 2 has a substantially U-shaped geometry with a U-base 12c and with a first and a second U-leg 12a, 12b, the first zone section 4a being part of the first U-leg 12a and the second zone section 4b being part of the second U-leg 12b.

Figure 1b shows a variant of the first example. In contrast to the first example, in the second example according to figure 1b there are two main current paths 10 thus two first zone sections 4a. The second zone section 4b is arranged perpendicular to the longitudinal direction L between the first two zone sections 4a.

As shown in Figure 1b, the breakthrough 7 has a U-shaped geometry with a base 13c and a first and second leg 13a, 13b. The first leg 13a of the breakthrough 7 separates the second zone section 4b perpendicular to the longitudinal direction L from one of the first two zone sections 4a. The second leg 13b of the breakthrough 7 separates the second zone section 4b perpendicular to the longitudinal direction L from the other of the first two zone sections 4a.

In both examples, the first and second terminals 5a, 5b are configured for electrically connecting the main current path 9 to an electrical power source 34 (not shown in Figures 1a, 1b). The third terminal 5c is configured for connecting the bypass path 10 to an electronic evaluation circuit 21 (not shown in Figures 1a, 1b).

As shown in Figures 1a and 1b respectively, in a plan view of its upper side 6 along a vertical direction H, the measuring resistor 2 has the outer contour of a rectangle 15 with two longitudinal sides 16 extending in the longitudinal direction L and two broad sides 17 extending in the width direction B, i.e. perpendicular to the longitudinal direction L. The e vertical direction H of the measuring resistor 2 extends perpendicular to both the longitudinal direction L and the width direction B. The two sides 17 extend along the width direction B, i.e. perpendicular to the longitudinal direction L. The two sides 17 extend along the width direction H. A length I of the longitudinal sides 16 measured in the longitudinal direction L is at least 1.5 times the width b of the broad sides 17 measured in the width direction b. A thickness d of the measuring resistance 2 measured along the vertical direction H is at most 1/5 of the width of the broad sides 17. Alternatively or in addition to this, the thickness can be at most 1/20 of the length of the longitudinal sides 16.

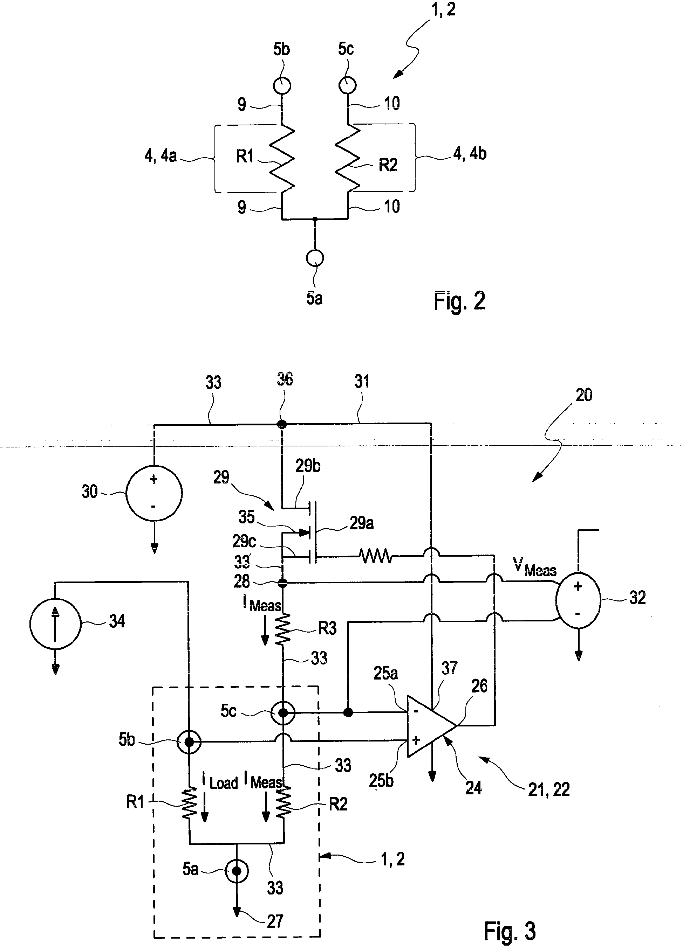

Figure 2 shows an equivalent circuit diagram for the current sensor 1 of Figure 1, showing the electrical resistance of the electrical current sensor. Accordingly, in the following the first electrical resistance between the first electrical terminal 5a and the second electrical terminal 5b is denoted as R1. The second electrical resistance between the first electrical terminal 5a and the third electrical terminal 5c is denoted as R2 in the following. The electrical resistance R2 is thus the resistance of the cavity 7 between the first and the third terminal 5a, 5c. In the following, the ratio of the two electrical resistances R1 and R2 to each other is denoted as the coefficient K. The coefficient K = R1/R2 is to be determined in the course of the calibration of the current sensor 1 and may be saved for the later determination of the electric current.

The resistive value of R1 is preferably chosen the same way a standard shunt is selected. It is a compromise between power dissipation and voltage developed across it. The lower the value of R1, the less power is lost as heat, but also the more sensitive the measuring circuit has to be. The value of R2 is as high as is practically achievable with the manufacturing method chosen. The higher the value of R2, the less test current needs to flow through it and the lower the power consumption of the compensating circuit.

Figure 3 shows a measuring circuit 20 for determining an electric current with an electrical current sensor 1 as presented above. The measuring circuit 20 comprises an evaluation circuit 21, which is illustrated as a circuit diagram in Figure 3 and is electrically connected to the electrical current sensor 1 or its electrical terminals 5a, 5b, 5c. The evaluation circuit 21 furthermore comprises a feedback circuit 22.

When the electrical current sensor 1 is electrically energized, the electric current flowing as a start point from the first terminal 5a through the entire measuring section 4 is denoted in the following as $I_{Total}$. The partial current of $I_{Total}$ flowing from the first electrical terminal 5a through the cavity 7 with the electrical resistance R2 to the third electrical terminal 5c is denoted in the following as the electrical measuring current $I_{Measure}$.

The partial current of $I_{Total}$ flowing from the first electrical terminal 5a through the measuring section 4 bypassing the cavity 7 with the electrical resistance R1 to the second electrical terminal 5b is denoted in the following as the electrical load current $I_{Load}$.

Thus, for the electric current through the measuring section 4 of the current sensor 1 the relation $I_{Total} = I_{Measure} + I_{Load}$ applies.

As can be seen from Figure 3, for the electrical energization of the current sensor 1 the second electrical terminal 5b of the current sensor 1 is hooked up to an electrical current source 34. The first electrical terminal 5a is electrically short-circuited by an earth potential 27. Thus, the electrical load current $I_{Load}$ can flow on the electrical conduction path from the first to the second electrical terminal 5a, 5b - this has the electrical resistance R1 - and thus from the current source 34 to the earth potential 27.

As can be furthermore seen from Figure 3, the cavity 7 is electrically energized by means of an electrical voltage supply source 30, which is connected across a conduction path 33, in which a power transistor 29 is arranged, to the third electrical terminal 5c. A source-drain channel 35 of the power transistor 29 thus receives the flow of electric current $I_{Measure}$ which is generated by the electrical voltage supply source 30.

The electrical voltage supply source 30 may also be used to provide the operational amplifier 24 with electric energy. For this, an electrical power supply line 31 leading to the power supply terminal 37 of the operational amplifier 24 branches off at a branching point 35 from the electrical conduction path 33 coming from the voltage supply source 36.

In the electrical conduction path 33 between the power transistor 29 and the third terminal 5c of the electrical current sensor 1, an ohmic resistor R3 is arranged in electrical series with the power transistor 29 and also in series with the electrical resistance R2 of the current sensor 1. The electric current flowing through the resistor R3 - and thus also the electric current $I_{Measure}$ through R2 - can be determined by means of a difference amplifier 32, which measures the electrical voltage dropping at the electrical resistance R3 when electrically energized with the measuring current $I_{Measure}$. This electrical voltage is a measure of the electric current $I_{Measure}$. Alternatively, instead of using a difference amplifier 32, the two connections coming from R3 can be fed to two analog inputs of a microcontroller, which can then measure their voltage and compute the difference.

In the following, it is explained how the electrical load current $I_{Load}$ can be determined by means of the evaluation circuit 21. The evaluation circuit 21 makes it possible herein to determine the load current $I_{Load}$ regardless of any thermal drifts occurring in the electrical measuring resistor 2. In other words, temperature-related errors in the determination of the electrical load current $I_{Load}$ are largely or even entirely completely prevented in the current sensor 1 presented here in combination with the evaluation circuit 21.

The evaluation circuit 21 as per Figure 3 comprises a feedback circuit 22. The feedback circuit 22 comprises an amplifier 24 provided with an inverting input 25a, with a non-inverting input 25b and with an output 26. The second electrical terminal 5b of the electrical current sensor 1 is electrically herein short-circuited by the non-inverting input 25b. The third electrical terminal 5c of the electrical current sensor 1 is accordingly electrically short-circuited by the inverting input 25a of the operational amplifier 24. The first electrical terminal 5a is electrically short-circuited by the earth potential 27. In order to form the feedback circuit 22, the output 26 is electrically connected to the control terminal ("gate") 29a of the power transistor 29. In this way, the operational amplifier 24 controls or adjusts the source-drain channel 35 present between the source terminal 29b and the drain terminal 29c of the power transistor 29 and thus the electric current $I_{Measure}$ flowing through this channel 35.

The feedback circuit 22 shown in Figure 3, by actuating the control terminal 29a across the output 26 of the operational amplifier 24, has the effect that the two inputs 25a, 25b of the operational amplifier 26 and thus the second and third electrical terminal 5b, 5c connected to these inputs are at the same electrical potential V2, V3, i.e., V2 = V3. The feedback essential to the temperature-independent measurement of the electric current $I_{Load}$ occurs here by controlling the electric current $I_{Measure}$ with the aid of the power transistor 29.

With the aid of the feedback circuit 22, as explained above, it is ensured that the voltage at the third electrical terminal 5c and at the second electrical terminal 5b have the same electrical voltage values V2, V3, i.e., V2 = V3.

Therefore, the following relation (1) follows for the electric current $I_{Load}$ between the two electrical terminals 5a, 5b, i.e., through the electrical resistance R1:

$$(1)\ I_{Load} = I_{Measure}\ /\ K$$

Since the coefficient K = R1/ R2 is known, to determine the load current $I_{Load}$ the electric current $I_{Measure}$ through the cavity 7 with the electrical resistance R2 must be ascertained.

The second electrical resistance R2 as part of the measuring resistor 2 and the third electrical resistance R3 are thus electrically hooked up to one another in series, so that each time the same electric current flows through them. The third electrical resistance R3 serves for determining the electric current through the second electrical resistance R2. For this, the electrical voltage $V_{Mess}$ dropping at the third electrical resistance R3 is determined by means of a difference amplifier 32.

Thanks to the electrical series circuit of the two electrical resistances R2, R3, the same electric current $I_{Measure}$ flows through both R2 and through R3.

But this electric current $I_{Measure}$ is dependent only on the ratio K of the two resistance values R1, R2 to each other. A temperature-related change in the first resistance R1 (e.g., by 1%) leads to the same temperature-related change (that is likewise by 1%) in the second resistance R2, so that the ratio K remains unchanged. In other words, the electric current $I_{Measure}$ through the resistance R3 and thus also through the resistance R2 can be determined independently of the temperature dependency of the two electrical resistances R1 = R1(T) and R2 = R2(T).

## Claims

1. Electrical current sensor (1) for determining an electrical current ($I_{Load}$) passed through said sensor (1),

   - with an electrical measuring resistor (2), which has a resistance zone (4) made of a shunt material, which is divided by a breakthrough (7) into at least a first and a second zone section (4a, 4b),
   - wherein at least one main electrical current path (9) is defined in the electrical measuring resistor (2) and extends from a first electrical terminal (5a) via the at least one first zone section (4a) to a second electrical terminal (5b); and
   - wherein an electrical bypass path (10) is defined in the electrical measuring resistor (2) and extends from the first electrical terminal (5a) via the second zone section (4b) to a third electrical terminal (5c).

2. Current sensor according to claim 1,
   **characterised in that**
   said at least a first zone portion (4a) and said second zone portion (4b) and said aperture (7) extend along a common longitudinal direction (L) of said current sensor (1).

3. Current sensor according to claim 1 or 2,
   **characterised in that**
   exactly one first zone section (4a) and exactly one breakthrough (7) are provided.

4. Current sensor according to any of claims 1 to 3,
   **characterised in that**
   the measuring resistor (2) has a substantially U-shaped geometry with a U-base (12a) and with first and second U-arms (12b, 12c), wherein the first zone portion (4a) is part of the first U-arm (12a) and the second zone portion (4b) is part of the second arm (12b).

5. Current sensor according to claim 1 or 2,
   **characterised in that**

   - two first zone sections (4a) are provided,
   - the second zone section (4b) is arranged transversely to the longitudinal direction (L) between the two first zone sections (4a).

6. Current sensor according to claim 5,
   **characterised in that**
   the aperture (7) has a U-shaped geometry with a base (13a) and first and second legs (13b, 13c), the two legs (13b, 13c) separating the second zone portion (4b) from each of the first two zone portions (4a).

7. Current sensor according to one of the preceding claims,
   **characterised in that**
   the opening (7) is of slot-like design.

8. Current sensor according to one of the preceding requirements,
   **characterised in that**
   said first and second terminals (5a, 5b) are configured for electrically connecting said main current path (9) to an electric power source (34), and said third terminal (5c) configured for electrically connecting said bypass current path (10) to an electronic evaluation circuit (21).

9. Measuring circuit (20) for determining an electric current ($I_{Load}$),

   - having an electrical current sensor (1) according to one of the preceding claims,
   - wherein the electrical current sensor (1) is electrically connected to an electronic evaluation circuit (21), by means of which the electric current ($I_{Load}$), flowing through the measuring section (4) of the electrical measuring resistor can be determined.

10. Measuring circuit according to Claim 9,
    **characterized in that**
    the measuring circuit (20) comprises a feedback circuit (22), designed such that by means of these temperature-related fluctuations of the resistance value of the measuring resistor (2) when determining the electric current are compensated.

Fig. 1 a

Fig. 1 b

8

Fig. 2

Fig. 3

Europäisches
Patentamt
European
Patent Office
Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/266269 A1 (AUSSERLECHNER UDO [AT] ET AL) 18 September 2014 (2014-09-18) | 1-9 | INV. G01R1/20 G01R19/00 |
| Y | * abstract; claims 1-25; figures 1-24 * * paragraph [0007] - paragraph [0012] * * paragraph [0040] - paragraph [0237] * | 10 | |
| X | US 2017/059632 A1 (PARKMAN IGOR B [US]) 2 March 2017 (2017-03-02) * abstract; claims 1-19; figures 1-7 * * paragraph [0011] - paragraph [0020] * * paragraph [0029] - paragraph [0066] * | 1-9 | |
| X | DE 33 24 224 A1 (LANDIS & GYR AG [CH]) 13 December 1984 (1984-12-13) * abstract; claims 1-7; figures 1-5 * * page 4, line 3 - line 27 * * page 5, line 1 - page 8, line 24 * | 1-9 | |
| X | US 2014/184199 A1 (MUELLER BERND [DE] ET AL) 3 July 2014 (2014-07-03) * abstract; claims 10-18; figures 1a-10b * * paragraph [0006] - paragraph [0013] * * paragraph [0030] - paragraph [0050] * | 1-9 | |
| X | CA 1 293 994 C (GEN ELECTRIC [US]) 7 January 1992 (1992-01-07) * abstract; claims 1-22; figures 1-7 * * page 4, line 2 - page 8, line 24 * * page 9, line 27 - page 17, line 30 * | 1-9 | TECHNICAL FIELDS SEARCHED (IPC) G01R |
| X | US 2003/020453 A1 (TRUMPLER WALTER [DE] ET AL) 30 January 2003 (2003-01-30) * abstract; claims 1-12; figures 1-5 * * paragraph [0004] - paragraph [0016] * * paragraph [0023] - paragraph [0045] * | 1-9 | |

-/--

The present search report has been drawn up for all claims

| Place of search | Date of completion of the search | Examiner |
|---|---|---|
| Munich | 18 May 2020 | Nadal, Rafael |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
..................................................................
& : member of the same patent family, corresponding
document

EPO FORM 1503 03.82 (P04C01)

page 1 of 2

Europäisches
Patentamt

European
Patent Office

Office européen
des brevets

## EUROPEAN SEARCH REPORT

Application Number

EP 19 20 9775

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2005/017760 A1 (GRASSO MASSIMO [IT] ET AL) 27 January 2005 (2005-01-27)<br>* abstract; claims 1-27; figures 1-6 *<br>* paragraph [0012] - paragraph [0014] *<br>* paragraph [0022] - paragraph [0048] *<br>----- | 10 | |

TECHNICAL FIELDS
SEARCHED      (IPC)

The present search report has been drawn up for all claims

| Place of search | Date of completion of the search | Examiner |
|---|---|---|
| Munich | 18 May 2020 | Nadal, Rafael |

EPO FORM 1503 03.82 (P04C01)

page 2 of 2

## ANNEX TO THE EUROPEAN SEARCH REPORT
## ON EUROPEAN PATENT APPLICATION NO.

EP 19 20 9775

This annex lists the patent family members relating to the patent documents cited in the above-mentioned European search report.
The members are as contained in the European Patent Office EDP file on
The European Patent Office is in no way liable for these particulars which are merely given for the purpose of information.

18-05-2020

| Patent document cited in search report | | Publication date | Patent family member(s) | | Publication date |
|---|---|---|---|---|---|
| US 2014266269 | A1 | 18-09-2014 | CN 104049130 A<br>DE 102014103343 A1<br>US 2014266269 A1 | | 17-09-2014<br>18-09-2014<br>18-09-2014 |
| US 2017059632 | A1 | 02-03-2017 | NONE | | |
| DE 3324224 | A1 | 13-12-1984 | CH 659895 A5<br>DE 3324224 A1 | | 27-02-1987<br>13-12-1984 |
| US 2014184199 | A1 | 03-07-2014 | DE 102011078334 A1<br>EP 2726885 A1<br>JP 5813220 B2<br>JP 2014520269 A<br>KR 20140034863 A<br>US 2014184199 A1<br>WO 2013000621 A1 | | 03-01-2013<br>07-05-2014<br>17-11-2015<br>21-08-2014<br>20-03-2014<br>03-07-2014<br>03-01-2013 |
| CA 1293994 | C | 07-01-1992 | NONE | | |
| US 2003020453 | A1 | 30-01-2003 | AT 277356 T<br>AU 4230301 A<br>DE 10013345 A1<br>EP 1297346 A2<br>US 2003020453 A1<br>WO 0169269 A2 | | 15-10-2004<br>24-09-2001<br>04-10-2001<br>02-04-2003<br>30-01-2003<br>20-09-2001 |
| US 2005017760 | A1 | 27-01-2005 | US 2005017760 A1<br>US 2006049854 A1 | | 27-01-2005<br>09-03-2006 |

EPO FORM P0459

For more details about this annex : see Official Journal of the European Patent Office, No. 12/82